# EUROPÄISCHE PATENTANMELDUNG

(11) **EP 4 092 358 A1**
(43) Veröffentlichungstag der Anmeldung: **23.11.2022**
(21) Anmeldenummer: 22171975.0
(22) Anmeldetag: 06.05.2022
(51) Int. Cl.: F25B 21/02

(54) **PELTIER-MODUL**

(30) Priorität: 21.05.2021 DE 102021113357
(71) Anmelder: Binder GmbH, 78532 Tuttlingen (DE)
(72) Erfinder: Deking, Kjell, 78083 Dauchingen (DE); Ndubueze, Emeka, 78532 Tuttlingen (DE); Buschle, Jochen, 78532 Tuttlingen (DE)
(74) Vertreter: Westphal, Mussgnug & Partner Patentanwälte mbB

(57) **Zusammenfassung**

Die Erfindung betrifft Peltier-Modul (10) mit wenigstens einem Peltier-Element (20) mit einer ersten Oberfläche (21) und einer gegenüberliegenden zweiten Oberfläche (22), wobei an der ersten Oberfläche (21) ein erstes Wärmeübertragungselement(31) eines Lüftungskanals (30) angeordnet ist, wobei der Lüftungskanal (30) zur Führung von Luft entlang des ersten Wärmeübertragungselements (31) eine Eingangsöffnung (36), in welcher ein Lüfter (34) angeordnet ist, und eine Ausgangsöffnung(37) aufweist, und wobei an der zweiten Oberfläche (22) ein zweites Wärmeübertragungselement (41) eines Kühlkörpers (40) angeordnet ist, wobei der Lüfter (34) derart ausgebildet und angeordnet ist, dass ein von dem Lüfter (34) erzeugter Luftstrom in einem Winkel (α) zwischen 10° und 80° zur ersten Oberfläche (21) angeordnet ist, sowie einen Laborschrank (50), einen Kühlschrank, einen Kälteschrank, einen Klimaschrank oder einen Umweltsimulationsschrank mit wenigstens einem derartigen Peltier-Modul (10).

## Beschreibung

Die Erfindung betrifft ein Peltier-Modul, welches beispielsweise in Laborschränken, Kühlschränken, Kälteschränken, Klimaschränken oder Umweltsimulationsschränken zur Kühlung des Innenraums zum Einsatz kommen kann.

Bekannt sind Peltier-Elemente, welche bei Stromdurchfluss eine Temperaturdifferenz erzeugen. Derartige Peltier-Elemente können zur Kühlung verwendet werden, beispielsweise in Kühl- oder Kälteschränken oder auch in Laborschränken, Klimaschränken oder Umweltsimulationsschränken. Ein Peltier-Element ist üblicherweise quaderförmig ausgebildet und weist eine erste Oberfläche und eine gegenüberliegende zweite Oberfläche auf. Die erste Oberfläche ist insbesondere Teil einer ersten Seite, insbesondere eine wärmere Seite, und die zweite Oberfläche ist insbesondere Teil einer zweiten Seite, insbesondere eine kältere Seite. Ein Peltier-Element kann üblicherweise eine maximale Temperaturdifferenz herstellen. Es ist bekannt, an der zweiten Oberfläche des Peltier-Elements ein Kühlelement anzuordnen, welches der Umgebung Wärme entzieht.

Um eine besonders effektive Kühlung zu erreichen, ist es weiterhin bekannt, die erste Seite des Peltier-Elements mittels eines Lüfters zu belüften, um den Kühleffekt zu verstärken. Dabei ist es bekannt, entweder senkrecht auf die Seite oder parallel zu dieser eine Luftströmung zu erzeugen.

Die Aufgabe der Erfindung besteht darin, ein Peltier-Modul mit einem verbesserten Wirkungsgrad bereitzustellen.

Die Aufgabe wird erfindungsgemäß gelöst durch ein Peltier-Modul mit den Merkmalen des Patentanspruchs 1.

Vorteilhafte Ausgestaltungen und Weiterbildungen sind in den abhängigen Ansprüchen angegeben.

Ein erfindungsgemäßes Peltier-Modul mit wenigstens einem Peltier-Element mit einer ersten Oberfläche und einer gegenüberliegenden zweiten Oberfläche, wobei an der ersten Oberfläche ein erstes Wärmeübertragungselement eines Lüftungskanals angeordnet ist, wobei der Lüftungskanal zur Führung von Luft entlang des ersten Wärmeübertragungselements eine Eingangsöffnung, in welcher ein Lüfter angeordnet ist, und eine Ausgangsöffnung aufweist, und wobei an der zweiten Oberfläche ein zweites Wärmeübertragungselement eines Kühlkörpers angeordnet ist, zeichnet sich dadurch aus, dass der Lüfter derart ausgebildet und angeordnet ist, dass ein von dem Lüfter erzeugter Luftstrom in einem Winkel zwischen 10° und 80° zur ersten Oberfläche angeordnet ist. Die erste Oberfläche und die zweite Oberfläche sind dabei insbesondere parallel zueinander angeordnet. Eine derartige Anströmung verbessert den Kühleffekt an der ersten Oberfläche, da Wärme besser von der Luft aufgenommen und durch den Lüftungskanal abgeführt werden kann.

Eine besonders vorteilhafte Weiterbildung der Erfindung sieht vor, dass der Lüfter als Axiallüfter mit einer Drehachse ausgebildet ist, wobei die Drehachse in einem Winkel zwischen 10° und 80° zur ersten Oberfläche angeordnet ist. Ein Axiallüfter kann trotz der Schrägstellung, die einen erhöhten Platzbedarf mit sich bringt, möglichst platzsparend an dem Lüftungskanal angeordnet werden.

Vorzugsweise beträgt der Winkel zwischen 10° und 50°, besonders bevorzugt zwischen 25° und 30°. Bei einer derartigen Anordnung kann ein besonders guter Kühleffekt erreicht werden.

Gemäß einer bevorzugten Weiterbildung der Erfindung ist zwischen dem ersten Wärmeübertragungselement und dem zweiten Wärmeübertragungselement seitlich von dem Peltier-Element, insbesondere umlaufend um das Peltier-Element, eine Isolationsschicht angeordnet ist. Üblicherweise weist das Peltier-Element eine Querschnittsfläche auf, die kleiner ist als die Fläche des ersten Wärmeübertragungselements und/oder des zweiten Wärmeübertragungselements. Die Isolationsschicht kann Energieverluste im Bereich um das Peltier-Element verringern.

Vorzugsweise ist das Peltier-Element auf einem Abstandselement angeordnet ist, welches an dem zweiten Wärmeübertragungselement insbesondere einstückig angeordnet ist. Ein derartiges Abstandselement vergrößert den Abstand zwischen dem ersten Wärmeübertragungselement und dem zweiten Wärmeübertragungselement und ermöglicht eine Reduzierung des Wärmestromes zwischen den beiden Wärmeübertragungselements.

Vorzugsweise weist der Lüftungskanal Rippen auf, die sich von der Oberfläche des ersten Wärmeübertragungselements ausgehend senkrecht zu dieser Oberfläche in Richtung auf einen parallel zu dieser Oberfläche verlaufenden Abschnitt des Gehäuses erstrecken. Derartige Rippen verbessern die durch den Luftstrom erreichte Kühlwirkung spürbar.

In besonderem Maße gilt dies, wenn die Rippen sich bis zu dem parallel zu dieser Oberfläche verlaufenden Abschnitt des Gehäuse erstrecken, so dass im Lüftungskanal eine Vielzahl durchgehender Kühlkanäle erzeugt wird, deren Wände jeweils durch benachbarte Rippen und die diese verbindenden Abschnitte der Oberfläche des ersten Wärmeübertragungselements und des Gehäuses gebildet wird.

Darüber hinaus kann der mit den Rippen erzielbare Effekt noch weiter gesteigert werden, wenn die der Ausgangsöffnung gegenüber liegenden Stirnseiten der Rippen schräg verlaufen und in einer Ebene liegen, deren Normalenvektor ebenfalls im Winkel α zur ersten Oberfläche verläuft.

Vorteilhafterweise weist das Peltier-Modul wenigstens zwei Peltier-Elemente mit einer ersten Oberfläche und einer gegenüberliegenden zweiten Oberfläche auf, wobei an jedem der Peltier-Elemente an der ersten Oberfläche ein erstes Wärmeübertragungselement eines Lüftungskanals angeordnet ist, wobei der Lüftungskanal zur Führung von Luft entlang des ersten Wärmeübertragungselements eine Eingangsöffnung, in welcher ein Lüfter angeordnet ist, und eine Ausgangsöffnung aufweist, und wobei die beiden Peltier-Elemente mit ihrer zweiten Oberfläche an einem einzigen zweiten Wärmeübertragungselement eines Kühlkörpers angeordnet sind. Eine derartige Ausgestaltung kann den Kühleffekt weiter verbessern.

Vorzugsweise weist das Peltier-Element wenigstens zwei in Reihe geschaltete Teil-Peltier-Elemente auf. Durch eine derartige Ausgestaltung kann die Fläche des Peltier-Elements in gewünschter Weise ausgebildet werden. Weiterhin kann durch eine derartige Ausgestaltung eine vorgegebene Versorgungsspannung des Geräts, in welchem das Peltier-Element zur Anwendung kommt, besser genutzt werden. Beispielsweise können bei einer Versorgungsspannung von 24VDC zwei Teil-Peltier-Elemente mit einer Versorgungsspannung von jeweils 12VDC in Reihe geschaltet werden.

Eine bevorzugte Weiterbildung der Erfindung sieht vor, dass an dem Kühlkörper Kühlrippen angeordnet sind, welche insbesondere senkrecht zu der zweiten Oberfläche des Peltier-Elements angeordnet sind. Durch eine derartige Ausgestaltung kann der Entzug der Wärme aus der Umgebung des Kühlkörpers verbessert werden.

Vorteilhafterweise kommt ein erfindungsgemäßes Peltier-Modul in einem Laborschrank, einem Kühlschrank, einem Kälteschrank, einem Klimaschrank oder einem Umweltsimulationsschrank zur Anwendung.

Ein erfindungsgemäßer Laborschrank, Kühlschrank, Kälteschrank, Klimaschrank oder Umweltsimulationsschrank mit einem Innengehäuse, einem Außengehäuse, einer zwischen dem Innengehäuse und dem Außengehäuse angeordneten Isolationsschicht weist wenigstens ein erfindungsgemäßes Peltier-Modul auf, welches derart angeordnet ist, dass der Lüftungskanal auf der Außenseite des Außengehäuses und der Kühlkörper auf der Innenseite des Innengehäuses angeordnet ist.

Die Erfindung wird anhand eines in den Figuren dargestellten Ausführungsbeispiels ausführlich erläutert. Es zeigen:
- Figur 1: eine perspektivische Ansicht eines Ausführungsbeispiels eines erfindungsgemäßen Peltier-Moduls,
- Figur 2: eine weitere perspektivische Ansicht des erfindungsgemäßen Peltier-Moduls gemäß Figur 1,
- Figur 3: eine Explosionsdarstellung des Peltier-Moduls gemäß Figur 1 mit ausgeblendeter Abdeckplatte und ausgeblendeter Steuerelektronik,
- Figur 4: einen Längsschnitt durch einen Laborschrank mit einem Innengehäuse, einem Außengehäuse und wenigstens einem Peltier-Modul gemäß Figur 1,
- Figur 5: einen Ausschnitt einer Draufsicht auf die Innenseite des Innengehäuses des Laborschranks gemäß Figur 4 und
- Figur 6: einen Ausschnitt einer Draufsicht auf die Außenseite des Außengehäuses des Laborschranks gemäß Figur 4.

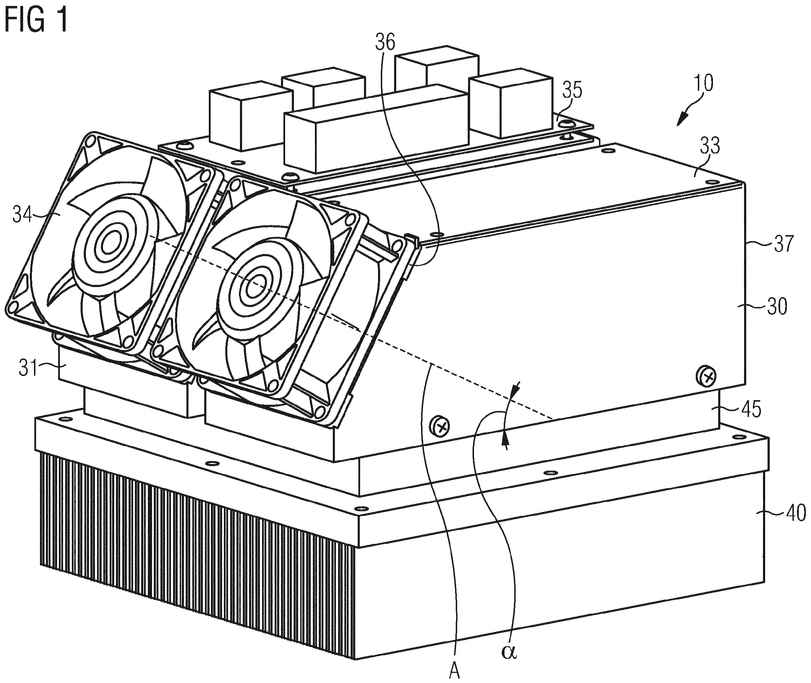

Die Figuren 1 bis 3 zeigen verschiedene Ansichten eines Ausführungsbeispiels eines erfindungsgemäßen Peltier-Moduls 10. Das Peltier-Modul 10 weist wenigstens einem Peltier-Element 20 mit einer ersten Oberfläche 21 und einer gegenüberliegenden zweiten Oberfläche 22 auf. Das Peltier-Element 20 kann beispielsweise etwa quaderförmig ausgebildet sein, wobei die erste Oberfläche 21 und die zweite Oberfläche 22 parallel zueinander ausgebildet sind. Das Peltier-Element 20 weist üblicherweise eine erste, wärmere Seite und eine zweite, kältere Seite auf, wobei vorliegend beispielsweise die erste Oberfläche 22 die Außenseite der ersten Seite und die zweite Oberfläche 23 die Außenseite der zweiten Seite bildet. Bei Stromdurchfluss durch das Peltier-Element 20 bildet sich eine Temperaturdifferenz zwischen der ersten Seite und der zweiten Seite aus.

Es ist möglich, dass das Peltier-Element 20 zwei oder mehr in Reihe geschaltete Teil-Peltier-Elemente 20a, 20b aufweist.

An der ersten Oberfläche 21 ist ein erstes Wärmeübertragungselement 31 eines Lüftungskanals 30 angeordnet. Der Lüftungskanal 30 ist zur Führung von Luft entlang des ersten Wärmeübertragungselements 31, insbesondere im Wesentlichen parallel zur Oberfläche 21 des Peltier-Elements 20, ausgebildet. Der Lüftungskanal 30 weist eine Eingangsöffnung 36, in welcher ein Lüfter 34 angeordnet ist, und eine Ausgangsöffnung 37, wobei insbesondere das Peltier-Element 20 in einer Projektion gesehen zwischen der Eingangsöffnung 36 und der Ausgangsöffnung 37 angeordnet ist. An dem ersten Wärmeübertragungselement 31 können Rippen 32 angeordnet sein, welche die Wärmeaufnahme undabgabe verbessern können.

Das Wärmeübertragungselement 31 kann insbesondere durch ein Gehäuse 33 abgedeckt sein, welches insbesondere die Eingangsöffnung 36 und die Ausgangsöffnung 37 umfassen kann. Der Lüftungskanal 30 erstreckt sich von der Eingangsöffnung 36 bis zur Ausgangsöffnung 37.

Der Lüfter 34 ist derart ausgebildet und angeordnet, dass ein von dem Lüfter 34 erzeugter Luftstrom in einem Winkel α zwischen 10° und 80°, vorzugsweise zwischen 10° und 50°, besonders bevorzugt zwischen 25° und 30°, zur ersten Oberfläche 21 angeordnet ist. Der Lüfter 34 kann beispielsweise als Axiallüfter mit einer Drehachse A ausgebildet sein, wobei die Drehachse A in dem beschriebenen Winkel α zur ersten Oberfläche angeordnet ist.

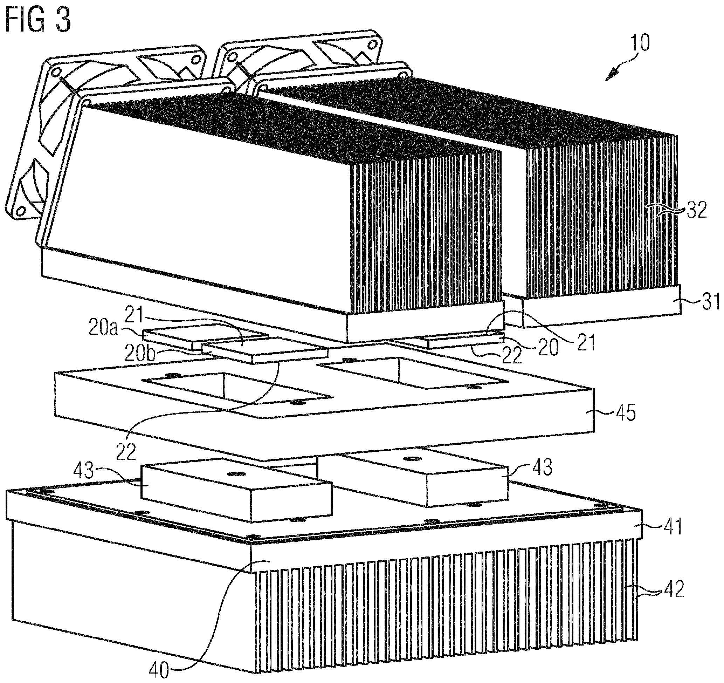

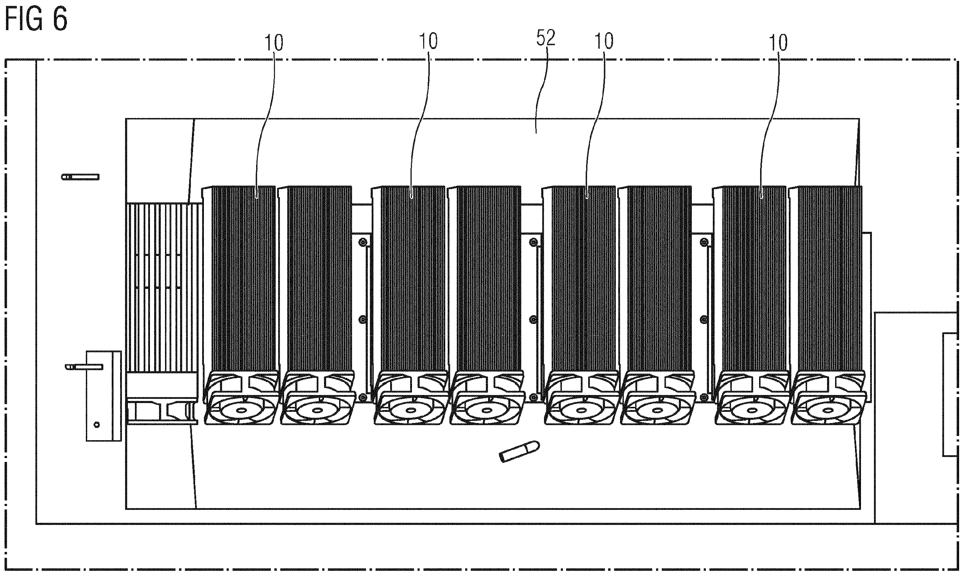

Wie man besonders gut in den Figuren 3 und 6 erkennt, ist die Geometrie der Rippen 32 an die Geometrie des Lüfters 34 angepasst, so dass der Luftstrom auf dem ganzen Weg zwischen Lüfter 34 und Ausgangsöffnung 37 zwischen den Rippen 32 geführt wird.

Konkret wird dies dadurch erreicht, dass der Lüfter 34 direkt an der der Ausgangsöffnung 37 gegenüber liegenden Stirnseite der Rippen 32 angeordnet ist, also unmittelbar oder im Abstand von einigen mm, und bevorzugt nicht nur mit einem Teilbereich sondern vollständig.

Dies wird insbesondere dadurch ermöglicht, dass diese Stirnseiten der Rippen 32 schräg verlaufen und in einer Ebene liegen, deren Normalenvektor ebenfalls im beschriebenen Winkel α zur ersten Oberfläche verläuft und durch die Richtung der Lüfterachse A beschrieben werden kann, wenn es sich um einen Axiallüfter handelt.

Zudem entspricht die Länge der Stirnseiten der Rippen 32 im Wesentlichen der Ausdehnung des Lüfters 34 in dieser Richtung. Der Luftstrom aus dem Lüfter 34 tritt über die gesamte Ausdehnung des Lüfters 34 unmittelbar zwischen die Rippen 32 ein. Jede dieser Maßnahmen trägt wesentlich zu einer besonders effizienten Kühlung durch den Luftstrom des Lüfters 34 bei.

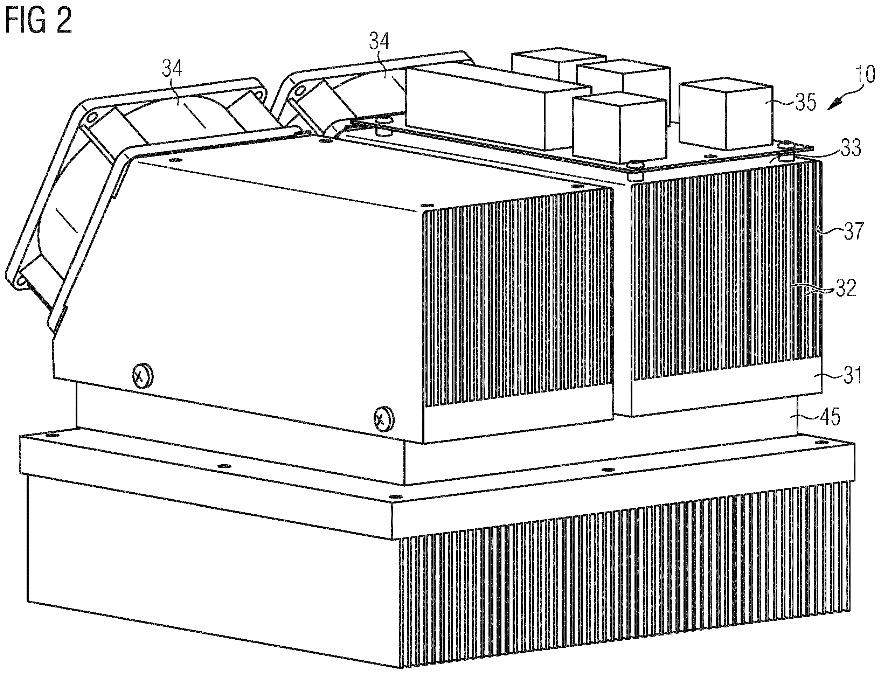

Gleichzeitig ist die Höhe der Rippen 32, wie in den Figuren 2 und 3 gut zu erkennen ist, vorzugsweise so gewählt, dass sie sich von der Oberfläche des ersten Wärmeübertragungselements 31 ausgehend senkrecht zu dieser Oberfläche bis zu einem parallel zu dieser Oberfläche verlaufenden Abschnitt des Gehäuses 33 erstrecken. Bevorzugt wird dadurch eine Vielzahl durchgehender Kühlkanäle erzeugt, deren Wände im Wesentlichen durch benachbarte Rippen 32 und die diese verbindenden Abschnitte der Oberfläche des ersten Wärmeübertragungselements 31 und des Gehäuses 33 gebildet wird, was ebenfalls die Kühlung weiter verbessert.

Das Peltier-Modul 10 kann eine Steuerelektronik 35 aufweisen, welche insbesondere an dem Gehäuse 33 angeordnet sein kann. Mittels der Steuerelektronik 35 kann beispielsweise die Drehzahl des Lüfters 34 geregelt werden. Weiterhin kann mittels der Steuerelektronik 35 die Stromstärke und ggfs. auch die Stromrichtung des durch das Peltier-Element 20 fließenden Stroms geregelt werden. Die Versorgungsspannung der Steuerelektronik 35 kann beispielsweise 24VDC betragen. Das Peltier-Element 20 kann eine Versorgungsspannung von 24VDC aufweisen. Jedes der Teil-Peltier-Elemente 20a, 20b kann beispielsweise eine Versorgungsspannung von 12VDC aufweisen.

An der zweiten Oberfläche 22 des Peltier-Elements 10 ist ein zweites Wärmeübertragungselement 41 eines Kühlkörpers 40 angeordnet. An dem Kühlkörper 40 können Kühlrippen 42 angeordnet sein, welche insbesondere senkrecht zu der zweiten Oberfläche 22 des Peltier-Elements 20 angeordnet sind.

Das Peltier-Element 20 kann auf einem Abstandselement 43 angeordnet sein (vgl. Fig. 3), welches an dem zweiten Wärmeübertragungselement 41 insbesondere einstückig angeordnet sein kann. Mittels des Abstandselements 43 kann der Abstand zwischen dem ersten Wärmeübertragungselement 31 und dem zweiten Wärmeübertragungselement 41 vergrößert werden, um den Wärmestrom zwischen dem ersten Wärmeübertragungselement 31 und dem zweiten Wärmeübertragungselement 41 verringern zu können.

Üblicherweise ist die Fläche des Peltier-Elements 20, d. h. insbesondere die Fläche der ersten Oberfläche 21 oder der zweiten Oberfläche 22, kleiner als die Fläche des ersten Wärmeübertragungselements 31 und/oder des zweiten Wärmeübertragungselements 41. Zur Isolierung kann dann zwischen dem ersten Wärmeübertragungselement 31 und dem zweiten Wärmeübertragungselement 41 seitlich von dem Peltier-Element 20, insbesondere umlaufend um das Peltier-Element 20, eine Isolationsschicht 45 angeordnet sein (vgl. Fig. 3). Ist das Peltier-Element 20 auf einem Abstandselement 43 angeordnet, kann die Isolationsschicht 45 auch umlaufend um das Abstandselement 43 angeordnet sein.

Das Peltier-Modul 10 kann wenigstens zwei Peltier-Elemente 20, in dem in den Figuren 1 bis 3 gezeigten Ausführungsbeispiel genau zwei Peltier-Elemente 20, jeweils mit einer ersten Oberfläche 21und einer gegenüberliegenden zweiten Oberfläche 22 aufweisen, wobei an jedem der Peltier-Elemente 20 an der ersten Oberfläche 21 ein erstes Wärmeübertragungselement 31 eines Lüftungskanals 30 angeordnet ist, wobei der Lüftungskanal 30 zur Führung von Luft entlang der ersten Wärmeübertragungselements 31 eine Eingangsöffnung 36, in welcher ein Lüfter 34 angeordnet ist, und eine Ausgangsöffnung 37 aufweist, und wobei die beiden Peltier-Elemente 20 mit ihrer zweiten Oberfläche 22 an einem einzigen zweiten Wärmeübertragungselement 41 eines Kühlkörpers 40 angeordnet sind. Die Steuerung der beiden Lüfter 34 und der beiden Peltier-Elemente 30 kann über eine gemeinsame Steuerelektronik 35 erfolgen.

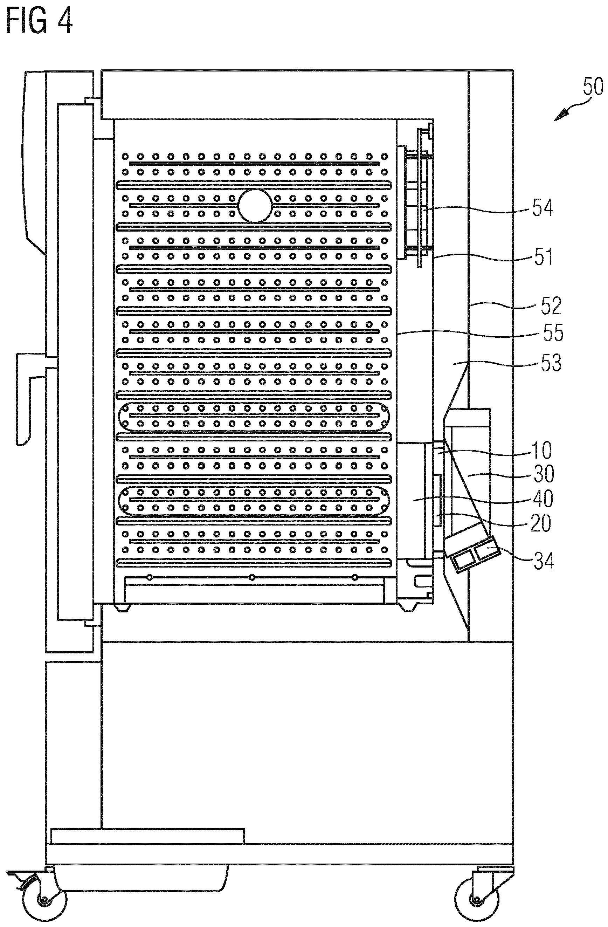

Die Figuren 4 bis 6 zeigen beispielhaft einen Laborschrank 50, mit wenigstens einem Peltier-Modul 10, insbesondere vier Peltier-Modulen 10, gemäß der Figuren 1 bis 3. Statt des Laborschranks 50 kann jedoch selbstverständlich ein Kühlschrank, ein Kälteschrank, ein Klimaschrank oder ein Umweltsimulationsschrank oder ein sonstiger Schrank, in welchem der Innenraum gekühlt werden soll, mit wenigstens einem Peltier-Modul gemäß der Figuren 1 bis 3 ausgestattet werden.

Der Laborschrank 50 weist ein Innengehäuse 51, ein Außengehäuse 52, und eine zwischen dem Innengehäuse 51 und dem Außengehäuse 52 angeordneten Isolationsschicht auf. Wie insbesondere in Figur 4 erkennbar, ist das wenigstens eine Peltier-Modul 10 derart angeordnet, dass der Lüftungskanal 30 auf der Außenseite des Außengehäuses 52 und der Kühlkörper 40 auf der Innenseite des Innengehäuses 51 angeordnet. Dabei soll als Außenseite des Außengehäuses 52 die Seite des Außengehäuses 52, welche dem Innengehäuse 51 abgewandt ist, und als Innenseite des Innengehäuses 51 die Seite des Innengehäuses, welche dem Außengehäuse 52 abgewandt ist, verstanden werden. Der Kühlkörper 40 kann beispielsweise von der Innenseite des Innengehäuses 51 angelegt und mittels Schrauben befestigt werden. Um durch die Schrauben verursachte Wärmebrücken zu vermeiden, können die Schrauben in einer isolierenden Hülse geführt angeordnet sein. Die Köpfe der Schrauben können mit einer isolierenden Kappe abgedeckt sein.

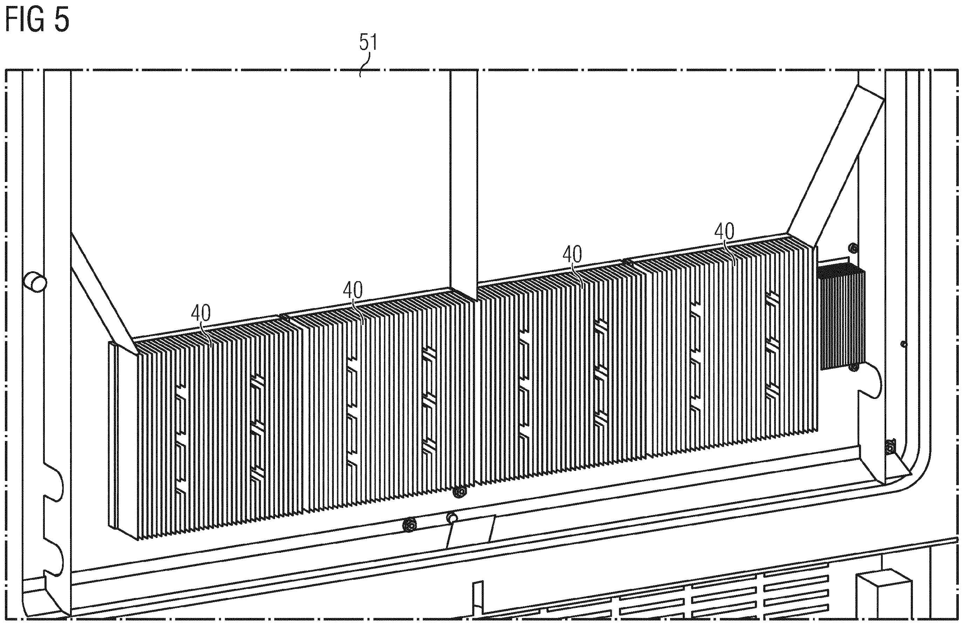

Figur 5 zeigt einen Ausschnitt einer Ansicht der Innenseite des Innengehäuses 51, in welcher mehrere, vorliegend vier, Kühlkörper 40 nebeneinander angeordnet sind derart, dass die Kühlrippen 42 in den Innenraum ragen. Es besteht die Möglichkeit, mittels eines weiteren Lüfters 54, der beispielsweise als Radiallüfter ausgebildet sein kann, Luft aus dem Innenraum des Innengehäuses 51 anzusaugen und entlang der Kühlrippe 42 des Kühlkörpers 40 zu führen, um die Wärmeübergabe zwischen Luft und Kühlrippen 42 zu verbessern. Für eine derartige Luftführung ist es vorteilhaft, beabstandet zur Wand des Innengehäuses eine Luftleitwand 55 anzuordnen.

### Bezugszeichenliste

- 10: Peltier-Modul
- 20: Peltier-Element
- 20a: Teil-Peltier-Element
- 20b: Teil-Peltier-Element
- 21: erste Oberfläche
- 22: zweite Oberfläche
- 30: Lüftungskanal
- 31: erstes Wärmeübertragungselement
- 32: Rippe
- 33: Gehäuse
- 34: Lüfter
- 35: Steuerelektronik
- 36: Eingangsöffnung
- 37: Ausgangsöffnung
- 40: Kühlkörper
- 41: zweites Wärmeübertragungselement
- 42: Kühlrippe
- 43: Abstandselement
- 45: Isolationsschicht
- 50: Laborschrank
- 51: Innengehäuse
- 52: Außengehäuse
- 53: Isolationsschicht
- 54: Lüfter
- 55: Luftleitwand
- α: Winkel
- A: Drehachse

## Patentansprüche

1. Peltier-Modul (10) mit wenigstens einem Peltier-Element (20) mit einer ersten Oberfläche (21) und einer gegenüberliegenden zweiten Oberfläche (22), wobei an der ersten Oberfläche (21) ein erstes Wärmeübertragungselement (31) eines Lüftungskanals (30) angeordnet ist, wobei der Lüftungskanal (30) zur Führung von Luft entlang des ersten Wärmeübertragungselements (31) eine Eingangsöffnung (36), in welcher ein Lüfter (34) angeordnet ist, und eine Ausgangsöffnung (37) aufweist, und wobei an der zweiten Oberfläche (22) ein zweites Wärmeübertragungselement (41) eines Kühlkörpers (40) angeordnet ist,
**dadurch gekennzeichnet, dass** der Lüfter (34) derart ausgebildet und angeordnet ist, dass ein von dem Lüfter (34) erzeugter Luftstrom in einem Winkel (α) zwischen 10° und 80° zur ersten Oberfläche (21) angeordnet ist.

2. Peltier-Modul nach einem der vorhergehenden Ansprüche, **dadurch gekennzeichnet, dass** der Lüfter (34) als Axiallüfter mit einer Drehachse (A) ausgebildet ist, wobei die Drehachse (A) in einem Winkel (α) zwischen 10° und 80° zur ersten Oberfläche (21) angeordnet ist.

3. Peltier-Modul nach einem der vorhergehenden Ansprüche, **dadurch gekennzeichnet, dass** der Winkel (α) zwischen 10° und 50°, besonders bevorzugt zwischen 25° und 30°, beträgt.

4. Peltier-Modul nach einem der vorhergehenden Ansprüche, **dadurch gekennzeichnet, dass** zwischen dem ersten Wärmeübertragungselement (31) und dem zweiten Wärmeübertragungselement (41) seitlich von dem Peltier-Element (20), insbesondere umlaufend um das Peltier-Element (20), eine Isolationsschicht (45) angeordnet ist.

5. Peltier-Modul nach einem der vorhergehenden Ansprüche, **dadurch gekennzeichnet, dass** das Peltier-Element (20) auf einem Abstandselement (43) angeordnet ist, welches an dem zweiten Wärmeübertragungselement (40) insbesondere einstückig angeordnet ist.

6. Peltier-Modul nach einem der vorhergehenden Ansprüche, **dadurch gekennzeichnet, dass** der Lüftungskanal (30) Rippen (32) aufweist, die sich von der Oberfläche des ersten Wärmeübertragungselements (31) ausgehend senkrecht zu dieser Oberfläche in Richtung auf einen parallel zu dieser Oberfläche verlaufenden Abschnitt des Gehäuses (33) erstrecken.

7. Peltier-Modul nach Anspruch 6,
**dadurch gekennzeichnet, dass** die Rippen (32) sich bis zu dem parallel zu dieser Oberfläche verlaufenden Abschnitt des Gehäuses (33) erstrecken, so dass im Lüftungskanal (30) eine Vielzahl durchgehender Kühlkanäle erzeugt wird, deren Wände jeweils durch benachbarte Rippen (32) und die diese verbindenden Abschnitte der Oberfläche des ersten Wärmeübertragungselements (31) und des Gehäuses (33) gebildet wird.

8. Peltier-Modul nach Anspruch 6 oder 7,
**dadurch gekennzeichnet, dass** die der Ausgangsöffnung (37) gegenüber liegenden Stirnseiten der Rippen (32) schräg verlaufen und in einer Ebene liegen, deren Normalenvektor ebenfalls im Winkel (α) zur ersten Oberfläche (21) verläuft.

9. Peltier-Modul nach einem der vorhergehenden Ansprüche, **dadurch gekennzeichnet, dass** das Peltier-Modul (10) wenigstens zwei Peltier-Elemente (20) mit einer ersten Oberfläche (21) und einer gegenüberliegenden zweiten Oberfläche (22) aufweist, wobei an jedem der Peltier-Elemente (20) an der ersten Oberfläche (21) ein erstes Wärmeübertragungselement (31) eines Lüftungskanals (30) angeordnet ist, wobei der Lüftungskanal (30) zur Führung von Luft entlang der ersten Wärmeübertragungselements (31) eine Eingangsöffnung (36), in welcher ein Lüfter (34) angeordnet ist, und eine Ausgangsöffnung (37) aufweist, und wobei die beiden Peltier-Elemente (20) mit ihrer zweiten Oberfläche (22) an einem einzigen zweiten Wärmeübertragungselement (41) eines Kühlkörpers (40) angeordnet sind.

10. Peltier-Modul nach einem der vorhergehenden Ansprüche,
**dadurch gekennzeichnet, dass** das Peltier-Element (20) wenigstens zwei in Reihe geschaltete Teil-Peltier-Elemente (20a, 20b) aufweist.

11. Peltier-Modul nach einem der vorhergehenden Ansprüche,
**dadurch gekennzeichnet, dass** an dem Kühlkörper (40) Kühlrippen (42) angeordnet sind, welche insbesondere senkrecht zu der zweiten Oberfläche (22) des Peltier-Elements (20) angeordnet sind.

12. Laborschrank (50), Kühlschrank, Kälteschrank, Klimaschrank oder Umweltsimulationsschrank mit wenigstens einem Peltier-Modul (10) nach einem der vorhergehenden Ansprüche.

13. Laborschrank (50), Kühlschrank, Kälteschrank, Klimaschrank oder Umweltsimulationsschrank mit einem Innengehäuse (51), einem Außengehäuse (52), einer zwischen dem Innengehäuse (51) und dem Außengehäuse (52) angeordneten Isolationsschicht (53) und wenigstens einem Peltier-Modul (10) nach einem der Ansprüche 1 bis 11, welches derart angeordnet ist, dass der Lüftungskanal (30) auf der Außenseite des Außengehäuses (52) und der Kühlkörper (40) auf der Innenseite des Innengehäuses (51) angeordnet ist.
